(19) Europäisches Patentamt
European Patent Office
Office européen des brevets

(11) **EP 4 723 213 A1**

(12) **EUROPEAN PATENT APPLICATION**
published in accordance with Art. 153(4) EPC

(43) Date of publication:
08.04.2026 Bulletin 2026/15

(21) Application number: 24870289.6

(22) Date of filing: 28.08.2024

(51) International Patent Classification (IPC):
*H01M 4/36* (2006.01)      *H01M 4/525* (2010.01)

(52) Cooperative Patent Classification (CPC):
C01B 32/05; C01G 49/00; C01G 53/82;
H01M 4/131; H01M 4/36; H01M 4/525; H01M 4/62;
H01M 10/0525; Y02E 60/10

(86) International application number:
PCT/CN2024/115014

(87) International publication number:
WO 2025/066743 (03.04.2025 Gazette 2025/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 27.09.2023  CN 202311262958

(71) Applicant: Shenzhen Yanyi New Materials Co.,
Ltd.
Shenzhen, Guangdong 518110 (CN)

(72) Inventors:
• CHEN, Junqi
  Shenzhen, Guangdong 518110 (CN)
• XIA, Fan
  Shenzhen, Guangdong 518110 (CN)
• YUE, Min
  Shenzhen, Guangdong 518110 (CN)

(74) Representative: Michalski Hüttermann & Partner
Patentanwälte mbB
Kaistraße 16A
40221 Düsseldorf (DE)

(54) **MODIFIED LITHIUM IRON(III) OXIDE MATERIAL, PREPARATION METHOD THEREFOR AND USE THEREOF**

(57)   The present application provides a modified lithium iron(III) oxide material, a method for preparing same, and use thereof. The modified lithium iron(III) oxide material comprises a nickel-doped lithium iron(III) oxide substrate, and an iron-nickel lithium oxide layer and a carbon coating layer sequentially stacked on the surface of the nickel-doped lithium iron(III) oxide substrate, wherein the iron-nickel lithium oxide layer is generated in situ on the surface of the nickel-doped lithium iron(III) oxide substrate, and in the modified lithium iron(III) oxide material, the molar ratio of lithium to iron is 5:(0.9 to 1.1), the molar ratio of nickel to lithium is (0.01 to 0.05):5, and the carbon coating content is 0.5 wt% to 5 wt%. The modified lithium iron(III) oxide material described herein comprises a unique thin nickel-iron-lithium oxide layer, and can significantly improve the stability of the lithium iron(III) oxide material and reduce or inhibit the generation of the residual base, thus possessing excellent lithium replenishment performance.

FIG. 1

## Description

### TECHNICAL FIELD

The present application relates to the field of lithium-ion battery materials, and in particular, to a modified lithium iron(III) oxide material, a method for preparing same, and use thereof.

### BACKGROUND

In the first charging and discharging process of a lithium-ion battery, a lithium-containing interface layer (solid electrolyte interphase, SEI) is formed on the surface of the negative electrode. The interface has the nature of a solid electrolyte and is crucial to the performance of the lithium-ion battery. The SEI film is insoluble in organic solvents and can be stably present in an organic electrolyte, so as to effectively prevent co-intercalation of solvent molecules and thereby improve the cycle performance and service life of the electrode. However, the formation of SEI consumes active lithium in the battery, resulting in a loss of the reversible capacity of the battery. At present, the initial coulombic efficiency of commercial graphite negative electrodes is usually about 90%, while the initial coulombic efficiency of silicon-based negative electrode materials, which have a higher specific capacity, is smaller, usually about 85% or even lower.

To make up for the active lithium loss in the first charging and discharging process, the prominent techniques at present include the positive-electrode lithium replenishment process and the negative-electrode lithium replenishment process. In terms of technical maturity, there are many manufacturers who are currently engaged in the production of materials and equipment related to metallic Li powder and Li foil for lithium replenishment and the research on lithium replenishment processes, suggesting high industrial maturity. However, the negative-electrode lithium replenishment imposes high requirements on equipment and environment and difficulties in ensuring the safety. In contrast, the positive-electrode lithium replenishment process features good safety and no impact on existing production processes. At present, fewer manufacturers and institutions are committed to the research on the positive-electrode lithium replenishment materials, and the preparation and modification of related lithium replenishment materials and the improvement of lithium replenishment processes await exploration.

As a lithium-rich material with a theoretical specific capacity of 867 mAh/g and a moderate operating voltage, lithium iron(III) oxide produces inert substances after the first charge and discharge, which do not participate in subsequent electrochemical processes. It is an ideal additive for the positive-electrode lithium replenishment.

CN108878849A discloses a synthesis process of a lithium-rich oxide and a lithium-ion battery containing the lithium-rich oxide, wherein the specific synthesis process of the lithium-rich oxide is as follows: taking a lithium source and an iron source in a proper molar ratio, dispersing them in deionized water, and adding a proper amount of an organic carbon source into the solution after complete dissolution; stirring the solution at 80 °C until a sol is formed; spray drying the sol to give a spherical precursor powder, then calcining the precursor powder in an inert gas atmosphere for a certain time, and cooling the precursor powder in a furnace to give a lithium-rich oxide with a core-shell structure $Li_5FeO_4/C$.

CN110459748A discloses a method for preparing a carbon-coated lithium iron(III) oxide material, which comprises the following steps: (1) mixing an iron source and a lithium source, and sintering to give lithium iron(III) oxide, wherein the molar ratio of the lithium source to the iron source is (5 to 25):1; (2) pulverizing the lithium iron(III) oxide obtained in step (1); and (3) subjecting the pulverized lithium iron(III) oxide in step (2) to gas-phase coating with a carbon source to give the carbon-coated lithium iron(III) oxide material.

The lithium iron(III) oxide materials described in the above solutions have the problems of a high amount of residual base and poor stability. Therefore, it is very necessary to develop a lithium iron(III) oxide material with a low amount of residual base and good stability.

### SUMMARY

The following is a summary of the subject matters in detail, which, however, is not intended to limit the claimed scope.

The present application provides a modified lithium iron(III) oxide material, a method for preparing same, and use thereof. In the present application, the lithium iron(III) oxide powder is subjected to a doping reaction with a nickel source, such that a unique thin nickel-iron-lithium oxide layer can be formed on the surface of the lithium iron(III) oxide material through mechanical grinding, the stability of the lithium iron(III) oxide material is significantly improved, and the generation of the residual base can be reduced or inhibited. Therefore, the lithium oxide material has excellent lithium replenishment performance.

In a first aspect, the present application provides a modified lithium iron(III) oxide material, wherein the modified lithium iron(III) oxide material comprises a nickel-doped lithium iron(III) oxide substrate, and an iron-nickel lithium oxide layer and a carbon coating layer sequentially stacked on the surface of the nickel-doped lithium iron(III) oxide substrate, wherein the iron-nickel lithium oxide layer is generated in situ on the surface of the nickel-doped lithium iron(III) oxide substrate, and in the modified lithium iron(III) oxide material, the molar ratio of lithium to iron is 5:(0.9 to 1.1) (e.g., 5:0.9, 5:0.95, 5:1, 5:1.05, 5:1.1, etc.), the molar ratio of nickel to lithium is (0.01 to 0.05):5 (e.g., 0.01:5, 0.02:5, 0.03:5, 0.04:5, 0.05:5, etc.), and the carbon coating content is 0.5 wt% to 5 wt%, e.g., 0.5 wt%, 1 wt%, 2 wt%, 3 wt%, 5 wt%, etc.

In the modified lithium iron(III) oxide material described herein, a unique thin nickel-iron-lithium oxide layer is formed on the surface of the lithium iron(III) oxide material, which can significantly improve the stability of the lithium iron(III) oxide material and reduce or inhibit the generation of the residual base. Therefore, the lithium oxide material has excellent lithium replenishment performance.

The amount of added nickel will affect the performance of the modified lithium iron(III) oxide material. The molar ratio of nickel in the nickel source to lithium in the lithium source is controlled at (0.01 to 0.05):5, and the prepared modified lithium iron(III) oxide material may have superior properties. If the amount of added nickel is insufficient, the materials may not react uniformly in the ball milling process, leading to limited improvements; if the amount of added nickel is excessive, the structure of the main phase lithium iron(III) oxide will be affected, resulting in reduced capacity.

In the modified lithium iron(III) oxide material provided herein, the carbon coating content is controlled at 0.5 wt% to 5 wt%, which can improve the electrical performance of the modified lithium iron(III) oxide material. Preferably, the carbon coating content is 0.8 wt% to 3 wt%, more preferably 1 wt% to 3 wt%, and even more preferably 1 wt% to 2.5 wt%, so as to provide better electrical performance.

According to the embodiments provided herein, the molar ratio of nickel to lithium includes, but is not limited to, 0.01:5, 0.02:5, 0.03:5, 0.04:5, 0.05:5, etc.

Preferably, the doping manner of nickel is grinding, more preferably ball milling. The nickel doping process does not include operations of high-temperature sintering and pulverization.

Preferably, the average thickness of the carbon coating layer is 10 to 500 nm, more preferably 80 to 400 nm, and even more preferably 100 to 300 nm.

In the present application, the method for testing the average thickness of the carbon coating layer is as follows: performing a SEM test of a powder section on the obtained modified lithium iron(III) oxide material, then selecting at least 10 points from the SEM cross-sectional view, calculating the thickness values, removing the maximum and minimum values, and calculating the average value to give the average thickness.

The coating described herein is full coating, that is, the carbon material achieves 100% coating of the nickel-doped lithium iron(III) oxide substrate.

In the modified lithium iron(III) oxide material provided herein, the carbon coating layer is a homogeneous carbon coating layer. The term "homogeneous" means that according to the SEM test results of the modified lithium iron(III) oxide material, the carbon material has no significant stacking or agglomeration phenomenon in at least 50% area outside the substrate, so as to provide better comprehensive performance.

Preferably, the carbon source forming the carbon coating layer is a gaseous carbon source, including, but not limited to, any one or a combination of at least two of ethylene, ethyne, methane, ethane, propylene, propane, and butene, and gaseous carbon sources of the same type that can achieve the same or similar effects may also be used in the present application.

According to some embodiments provided herein, the content of the residual base in the modified lithium iron(III) oxide material is less than 5%; according to some other embodiments provided herein, the content of the residual base in the modified lithium iron(III) oxide material is less than 4.5%; according to some embodiments provided herein, the content of the residual base in the modified lithium iron(III) oxide material is less than 3.5%.

The residual base includes LiOH and $Li_2CO_3$.

In a second aspect, the present application provides a method for preparing a modified lithium iron(III) oxide material, comprising the following steps:

(1) mixing a lithium source and an iron source, and sintering the mixture to give a lithium iron(III) oxide substrate;
(2) grinding the lithium iron(III) oxide substrate and a nickel source to give a nickel-doped lithium iron(III) oxide substrate; and
(3) subjecting the nickel-doped lithium iron(III) oxide substrate obtained in step (2) to gas-phase carbon coating with a carbon source to give the modified lithium iron(III) oxide material.

According to the present application, by means of the doping reaction of the lithium iron(III) oxide powder with the nickel source, a unique thin nickel-iron-lithium oxide layer can be formed on the surface of the lithium iron(III) oxide material through mechanical grinding by strictly controlling the molar ratio of lithium, iron, and nickel and providing appropriate process conditions, which can significantly improve the stability of the lithium iron(III) oxide material and reduce or inhibit the generation of the residual base. Therefore, the lithium oxide material has excellent lithium replenishment performance.

Preferably, in step (1), the lithium source includes any one or a combination of at least two of lithium oxide ($Li_2O$), lithium hydroxide (LiOH), lithium carbonate ($Li_2CO_3$), lithium chloride (LiCl), lithium nitrite ($LiNO_2$), lithium nitrate ($LiNO_3$),

lithium oxalate ($Li_2C_2O_4$), lithium acetate ($CH_3COOLi$), and lithium phosphate ($Li_3PO_4$).

Preferably, the iron source includes any one or a combination of at least two of ferric chloride ($FeCl_3$), ferrosoferric oxide ($Fe_3O_4$), ferric oxide ($Fe_2O_3$), ferric hydroxide ($Fe(OH)_3$), ferric oxyhydroxide ($FeO(OH)$), ferric nitrate ($Fe(NO_3)_3$), ferric acetate ($Fe(CH_3COO)_3$), ferric citrate ($FeC_6H_5O_2$), ferric phosphate ($FePO_4$), ferrous oxalate ($FeC_2O_4$) and ferric formate ($Fe(HCOO)_3$).

Preferably, the molar ratio of lithium in the lithium source to iron in the iron source is 5:(0.9 to 1.1), e.g., 5:0.9, 5:0.92, 5:0.95, 5:1, 5:1.1, etc.

Preferably, in step (1), the sintering comprises a primary sintering and a secondary sintering.

Preferably, the temperature of the secondary sintering is higher than that of the primary sintering.

Preferably, the primary sintering is performed at 100 °C to 250 °C for 0.5 to 4 h.

Preferably, the secondary sintering is performed at 600 °C to 900 °C for 5 to 20 h.

Preferably, in step (2), the nickel source includes any one or a combination of at least two of nickel monoxide ($NiO$), nickel trioxide ($Ni_2O_3$), nickel hydroxide ($Ni(OH)_2$), nickel oxide hydroxide ($NiO(OH)$), nickel nitrate ($Ni(NO_3)_2$), nickel nitrite ($Ni(NO_2)_2$), nickel carbonate ($NiCO_2$), nickel oxalate ($NiC_2O_4$), and nickel acetate ($Ni(CH_3COO)_2$).

Preferably, the molar ratio of nickel in the nickel source to lithium in the lithium source is (0.01 to 0.05):5, e.g., 0.01:5, 0.02:5, 0.03:5, 0.04:5, 0.05:5, etc.

Preferably, in step (2), the lithium iron(III) oxide substrate is crushed and sieved before the grinding;
Preferably, the number of meshes of the sieve is 400 to 500 meshes, such as 400 meshes, 420 meshes, 450 meshes, 480 meshes, 500 meshes, etc.

Preferably, the grinding includes mechanochemical ball milling.

Preferably, the ball-to-material ratio of the mechanochemical ball milling is (10 to 45):1, e.g., 10:1, 15:1, 20:1, 30:1, 40:1, 45:1, etc.

In the present application, the mechanochemical ball milling allows the excessive lithium on the surface of lithium iron(III) oxide particles to react with the nickel source to generate lithium nickel oxide, such that a thin layer of iron-nickel-lithium composite material is generated on the surface of the lithium iron(III) oxide particles to form an excellent core-shell structure. Since lithium nickel oxide is more stable than lithium iron(III) oxide, the amount of residual base generated can be effectively reduced, and the overall stability of the modified lithium iron(III) oxide material is improved. Lithium nickel oxide itself also has a certain lithium replenishment capacity.

Compared with the blending and sintering method, the mechanochemical ball milling method can control the reaction in the surface layer of the powder and, by replacing the high-temperature sintering method, avoid procedures such as pulverization and sieving after sintering.

Preferably, in step (3), the carbon source includes any one or a combination of at least two of ethylene, ethyne, methane, ethane, propylene, propane, and butene.

In the present application, the temperature for the gas-phase carbon coating is configured as per the decomposition temperatures of different carbon sources. The temperature for the gas-phase carbon coating is close to or higher than the decomposition temperature (decomposition may occur when the temperature is slightly lower, but may not be thorough), e.g., 700 °C to 1000 °C.

Preferably, in step (3), the gas-phase carbon coating is performed in an inert gas atmosphere.

Preferably, the inert gas atmosphere includes nitrogen and/or argon.

In the present application, the carbon source gas is sintered at a high temperature and deposited on the surface of the modified lithium iron(III) oxide material in the form of a nano carbon vapor, such that the material can be fully and completely coated, so as to improve the stability of the material, reduce the amount of the residual base, and improve the conductivity. Compared with the common blending and coating using carbon powder and the polymer coating, the size of carbon nanoparticles is smaller, and the surface modification and coating effect of the materials are better.

Furthermore, a better coating effect can be achieved by rotating the cavity of the chemical vapor deposition furnace at a rotation speed of 0.3 to 15.0 rpm, specifically, 0.5 to 10.0 rpm. When the rotation speed is insufficient, the modified lithium iron(III) oxide material at the bottom cannot easily contact with the carbon source gas; when the rotation speed is excessive, the powder may be spun during the centrifugation and compacted into a mass, which is not conducive to carbon coating.

Preferably, the time for the gas-phase carbon coating is 1 to 3 h.

In a third aspect, the present application provides a positive-electrode plate, comprising the modified lithium iron(III) oxide material according to the first aspect or a modified lithium iron(III) oxide material prepared by the method according to the second aspect.

In a fourth aspect, the present application provides a lithium-ion battery, comprising the positive-electrode plate according to the third aspect.

Compared with the related art, the present application has the following beneficial effects.

(1) According to the modified lithium iron(III) oxide material provided herein, by means of the doping reaction of the lithium iron(III) oxide powder with the nickel source, a unique thin nickel-iron-lithium oxide layer can be formed on the surface of the lithium iron(III) oxide material through mechanical grinding by controlling the molar ratio of lithium, iron, and nickel and providing appropriate process conditions, which can significantly improve the stability of the lithium iron(III) oxide material and reduce or inhibit the generation of the residual base. Therefore, the lithium oxide material has excellent lithium replenishment performance.

(2) In the present application, by performing the mechanochemical ball milling, the effect of chemical reaction is achieved mechanically, thereby avoiding the use of high-temperature sintering; without pulverization after sintering, the process and energy consumption can be reduced. In addition, by performing the mechanochemical ball milling, the nickel source can mainly react with the excessive lithium on the surface or surface layer of the lithium iron(III) oxide particles, and the produced iron-nickel-lithium composite oxide coats the surface of the lithium iron(III) oxide particles, which is beneficial to isolating lithium iron(III) oxide from the contact with moisture and oxygen in the external environment, reducing side reactions, improving the stability of the lithium iron(III) oxide powder, providing a protective effect, and helping inhibit or reduce the generation of the residual base.

(3) The modified lithium iron(III) oxide material provided herein uses a gaseous carbon source to form a homogeneous carbon coating layer, which has excellent electrical conductivity and can improve the electrochemical performance. In addition, the fully coated homogeneous carbon coating layer can better isolate air and further improve the environmental stability.

(4) The content of the residual base in the modified lithium iron(III) oxide described herein can be reduced to 1.56% or lower, the initial coulombic efficiency of the prepared battery may reach 85% or higher, the 3C-discharge capacity retention rate may reach 88% or higher, and the capacity retention rate may reach 99% or higher after 500 cycles at 25 °C.

Other aspects will be apparent upon reading and understanding the drawings and detailed description.

## BRIEF DESCRIPTION OF THE DRAWINGS

FIG. 1 illustrates a cross-sectional SEM image of the modified lithium iron(III) oxide material according to Example 1 of the present application;

FIG. 2 illustrates a SEM image of the modified lithium iron(III) oxide material according to Comparative Example 2 of the present application.

## DETAILED DESCRIPTION

The technical solutions of the present application are further illustrated with reference to the following specific examples. It will be appreciated by those skilled in the art that the examples are only intended to help understand the present invention and should not be construed as specific limitations to the present application.

Example 1

This example provides a modified lithium iron(III) oxide material. The procedures for preparing the modified lithium iron(III) oxide material are as follows:

(1) 298.81 g of lithium oxide (10 mol, equivalent to 20 mol of lithium) and 312.99 g of ferric oxide (1.96 mol, equivalent to 3.92 mol of iron) were mixed by using a mixer to give a mixed powder; in an argon atmosphere, the mixed powder was heated to 100 °C and incubated for 4.0 h, heated to 600 °C and incubated for 20.0 h, and sintered at a high temperature, and then naturally cooled to 25 °C to give lithium iron(III) oxide;

(2) In an argon atmosphere, lithium iron(III) oxide was broken up and crushed using a crusher, and the resulting mixture was sieved through a 500-mesh sieve; the residue in the sieve was crushed again; 2.99 g of nickel monoxide (0.04 mol, equivalent to 0.04 mol of nickel) was added, and the mixture was mixed by using a mixer to give a mixed powder of lithium iron(III) oxide and nickel monoxide; then, in an argon atmosphere, the mixed powder was subjected to mechanochemical ball milling in a ball mill for 5.0 h at a ball-to-material ratio of 30:1 to give a nickel-doped lithium iron(III) oxide substrate.

(3) In an argon atmosphere, 100 g of the nickel-doped lithium iron(III) oxide substrate obtained in step (2) was placed in a chemical vapor deposition furnace; the temperature was raised to 700 °C, and ethyne was then introduced; the cavity of the chemical vapor deposition furnace was rotated at a rotation speed of 0.5 rpm for 3.0 h with the temperature held; then the introduction of carbon source gas was stopped, and the temperature was lowered to 25 °C to give the modified lithium iron(III) oxide material with a carbon coating content of 1.4 wt%.

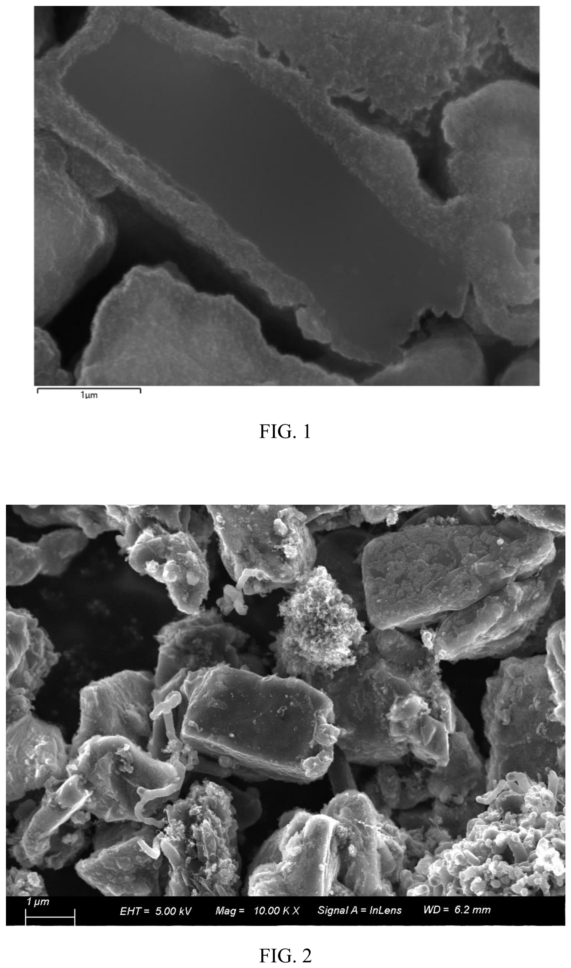

The cross-sectional SEM image of the modified lithium iron(III) oxide material is shown in FIG. 1. It can be seen from FIG. 1 that a coating layer is present on the surface of individual powder particles of the modified lithium iron(III) oxide prepared by the present application, and the average thickness of the coating layer was 200 nm.

Example 2

This example provides a modified lithium iron(III) oxide material. The procedures for preparing the modified lithium iron(III) oxide material are as follows:

(1) 298.81 g of lithium oxide (10 mol, equivalent to 20 mol of lithium) and 319.38 g of ferric oxide (2 mol, equivalent to 4 mol of iron) were mixed by using a mixer to give a mixed powder; in an argon atmosphere, the mixed powder was heated to 250 °C and incubated for 0.5 h, heated to 900 °C and incubated for 5.0 h, and sintered at a high temperature, and then naturally cooled to 25 °C to give lithium iron(III) oxide;
(2) In an argon atmosphere, lithium iron(III) oxide was broken up and crushed using a crusher, and the resulting mixture was sieved through a 500-mesh sieve; the residue in the sieve was crushed again; 14.94 g of nickel monoxide (0.2 mol, equivalent to 0.2 mol of nickel) was added, and the mixture was mixed by using a mixer to give a mixed powder of lithium iron(III) oxide and nickel monoxide; then, in an argon atmosphere, the mixed powder was subjected to mechanochemical ball milling in a ball mill for 0.5 h at a ball-to-material ratio of 10:1 to give a nickel-doped lithium iron(III) oxide substrate.
(3) In an argon atmosphere, 100 g of the nickel-doped lithium iron(III) oxide substrate obtained in step (2) was placed in a chemical vapor deposition furnace; the temperature was raised to 1000 °C, and ethane was then introduced; the cavity of the chemical vapor deposition furnace was rotated at a rotation speed of 10.0 rpm for 1.0 h with the temperature held; then the introduction of carbon source gas was stopped, and the temperature was lowered to 25 °C to give the modified lithium iron(III) oxide material.

The carbon coating content was 2.01 wt%, and the average thickness of the carbon coating layer was 300 nm.

Example 3

This example differs from Example 1 only in that the lithium source was replaced by 20 mol of lithium hydroxide, the iron source was 4.4 mol of ferric chloride, and the nickel source was 0.2 mol of nickel nitrate. The other conditions and parameters were completely the same as those in Example 1.

The carbon coating content was 1.4 wt%, and the average thickness of the carbon coating layer was 200 nm.

Example 4

This example differs from Example 1 only in that the lithium source was replaced by 10 mol of lithium oxalate, the iron source was 3.6 mol of ferric chloride, and the nickel source was 0.2 mol of nickel hydroxide. The other conditions and parameters were completely the same as those in Example 1.

The carbon coating content was 1.4 wt%, and the average thickness of the carbon coating layer was 200 nm.

Comparative Example 1

This comparative example differs from Example 1 only in that no nickel source was added. The other conditions and parameters were completely the same as those in Example 1.

The carbon coating content was 1.4 wt%, and the average thickness of the carbon coating layer was 200 nm.

Comparative Example 2

This comparative example differs from Example 1 only in that: in step (3), a solid phase coating process was performed, and the applied carbon source for the solid phase coating was changed to sucrose. The other conditions and parameters were completely the same as those in Example 1.

The carbon coating content was 0.87 wt%. The SEM image of the modified lithium iron(III) oxide material is shown in FIG. 2.

Comparative Example 3

This comparative example differs from Example 1 only in that the nickel source was directly mixed with the iron source and the lithium source for sintering, without mechanochemical ball milling. The other conditions and parameters were completely the same as those in Example 1.
The carbon coating content was 1.4 wt%, and the average thickness of the carbon coating layer was 200 nm.

Comparative Example 4

This comparative example differs from Example 1 only in that the mass of the nickel monoxide in step (2) was 2.4 g (0.032 mol, equivalent to 0.032 mol of nickel). The other conditions and parameters were completely the same as those in Example 1. The carbon coating content was 1.4 wt%, and the average thickness of the carbon coating layer was 200 nm.

Comparative Example 5

This comparative example differs from Example 1 only in that the mass of the nickel monoxide in step (2) was 19.74 g (0.24 mol, equivalent to 0.24 mol of nickel). The other conditions and parameters were completely the same as those in Example 1.
The carbon coating content was 1.4 wt%, and the average thickness of the carbon coating layer was 200 nm.

Performance testing:

0.3 g of lithium iron(III) oxide sample prepared in the examples or comparative examples was added to 100 mL of methanol. The mixture was stirred at 800 rpm for 5 min using a 3-cm magnetic stirrer and filtered under vacuum. The filtrate was measured using a Mettler GS20 automatic titrator to give the sum of residual bases LiOH and $Li_2CO_3$.

(1) LFP, the modified lithium iron(III) oxide materials obtained in Examples 1 to 4 and Comparative Examples 1 to 5, the conductive agent SuperP, carbon nanotube, and the binder polyvinylidene fluoride (PVDF) were uniformly mixed in a mass ratio of 94:2:1.5:0.5:2 in N-methylpyrrolidone (NMP) to prepare a positive-electrode slurry (with a solid content of 60%). The slurry was applied onto a current collector aluminum foil at an areal density of $340 \, g/cm^2$ in a double-sided manner. The current collector aluminum foil was dried at 70 °C, cold-pressed at room temperature at 4 MPa, trimmed, cut, slit, and welded to a tab to prepare a positive-electrode plate.
(2) Under an inert protective gas atmosphere, an artificial graphite negative-electrode material, the conductive agent SuperP, and the binder PVDF were uniformly mixed in a mass ratio of 97.5:1.0:1.5 in NMP to prepare a negative-electrode slurry (with a solid content of 50%). The slurry was applied onto a current collector copper foil with a thickness of 100 $\mu$m. The current collector copper foil was dried at 100 °C, cold-pressed at room temperature at 4 MPa, trimmed, cut, slit, and welded to a tab to prepare a negative-electrode plate.
(3) A PE porous polymer film was used as the separator. The prepared positive electrode plate, separator, and negative electrode plate were stacked in sequence such that the separator was positioned between the positive and negative electrode plates, and the stack was wound to give a bare cell. The bare cell was placed in an aluminum laminated film pouch and dried at 100 °C at a relative vacuum pressure of $-0.95 \times 10^5$ Pa until the moisture content was below 100 ppm. An electrolyte solution was injected into the dried bare cell, where the electrolyte solution contained ethylene carbonate (EC), ethyl methyl carbonate (EMC), diethyl carbonate (DEC) (EC:EMC:DEC = 1:1:1, v:v:v), and $LiPF_6$ (concentration: 1.0 M). The bare cell was packaged, left to stand, formed (charged at a constant current of 0.02 C for 2 h and at a constant current of 0.1 C for 2 h), shaped, and subjected to a capacity test (capacity grading), so as to prepare a soft pack lithium-ion battery.

1. Initial coulombic efficiency test:

The battery prepared above was subjected to formation and capacity grading using a battery test cabinet. The formation procedures are as follows: the battery was charged at a constant current of 0.05 C for 2.0 h, charged at a constant current of 0.15 C for 2.5 h, charged at a constant current of 0.33 C to 4.2 V, and charged at a constant voltage at a voltage of 4.2 V until a cut-off current of 0.02 C was reached, and discharged at 0.33 C to 2.5 V for capacity grading. The sum of the above charge capacities and the discharge capacity were recorded as the initial charge capacity and the initial discharge capacity, and the initial specific charge capacity, the initial specific discharge capacity, and the initial coulombic efficiency were calculated.

2. Room-temperature cycle performance test:

At 25 °C, the battery after the formation and capacity grading was charged to 3.7 V at a constant current and constant voltage of 0.5 C with a cut-off current of 0.02 C, let stand for 5 min, discharged to 2.5 V at a constant current of 1 C, and let stand for 5 min. According to this cycle, after 500 charge/discharge cycles, the capacity retention rate at the 500th cycle was calculated by the following formula:

500-cycle capacity retention rate (%) = (500-cycle discharge capacity/first-cycle discharge capacity) $\times$ 100%.

The test results are shown in Table 1:

Table 1

| | Residual base content (%) | Initial coulombic efficiency (%) | 3C discharge Capacity retention rate (%) | 25 °C cycle Capacity retention rate after 500 cycles (%) |
|---|---|---|---|---|
| Example 1 | 1.02 | 85.4 | 88.4 | 99.5 |
| Example 2 | 1.41 | 85.8 | 88.3 | 99.0 |
| Example 3 | 1.56 | 85.0 | 88.0 | 99.3 |
| Example 4 | 1.01 | 85.8 | 88.5 | 99.4 |
| Comparative Example 1 | 5.79 | 81.7 | 80.1 | 94.3 |
| Comparative Example 2 | 5.43 | 81.5 | 80.4 | 94.8 |
| Comparative Example 3 | 5.80 | 81.9 | 80.9 | 94.2 |
| Comparative Example 4 | 3.68 | 82.8 | 82.0 | 96.5 |
| Comparative Example 5 | 4.27 | 83.3 | 83.0 | 96.9 |

As can be seen from Table 1, the content of the residual base in the modified lithium iron(III) oxide in Examples 1 to 4 of the present application was 1.56% or lower, the initial coulombic efficiency of the prepared battery was 85% or higher, the 3C-discharge capacity retention rate was 88% or higher, and the capacity retention rate was 99% or higher after 500 cycles at 25 °C.

From the comparison between Example 1 and Comparative Example 1, it can be seen that according to the present application, by means of the doping reaction of the lithium iron(III) oxide powder with the nickel source, a unique thin nickel-iron-lithium oxide layer can be formed on the surface of the lithium iron(III) oxide material through mechanical grinding by controlling the molar ratio of lithium, iron, and nickel and providing appropriate process conditions, which can significantly improve the stability of the lithium iron(III) oxide material and reduce or inhibit the generation of the residual base. Therefore, the lithium oxide material has excellent lithium replenishment performance.

From the comparison between Example 1 and Comparative Example 2, it can be seen that according to the present application, the carbon source gas is sintered at a high temperature and deposited on the surface of the modified lithium iron(III) oxide material in the form of a nano carbon vapor, such that the material can be fully and completely coated, so as to improve the stability of the material, reduce the amount of the residual base, and improve the conductivity. For the solid phase coating, as can be seen from FIG. 2, the surface of the solid-phase coating was uneven, some of the particles were exposed and were not coated with the carbon layer, and it was difficult to form a homogeneous carbon coating layer on the coated part.

From the comparison between Example 1 and Comparative Example 3, it can be seen that according to the present application, the mechanochemical ball milling allows the excessive lithium on the surface of lithium iron(III) oxide particles to react with the nickel source to generate lithium nickel oxide, such that a thin layer of iron-nickel-lithium composite material is generated on the surface of lithium iron(III) oxide particles to form an excellent core-shell structure. Since lithium nickel oxide is more stable than lithium iron(III) oxide, the amount of residual base generated can be effectively reduced, and the overall stability of the modified lithium iron(III) oxide material is improved. Lithium nickel oxide itself also has a certain lithium replenishment capacity.

As can be seen from the comparison between Example 1 and Comparative Examples 4 and 5, the amount of added nickel in the modified lithium iron(III) oxide material described herein will affect the performance of the modified lithium iron(III) oxide material. The molar ratio of nickel in the nickel source to lithium in the lithium source is controlled at (0.01 to 0.05):5, and the prepared modified lithium iron(III) oxide material may have superior properties. If the amount of added nickel is insufficient, the materials may not react uniformly in the ball milling process, leading to limited improvements; if the amount of added nickel is excessive, the structure of the main phase lithium iron(III) oxide will be affected, resulting in reduced capacity.

It should be noted that the above descriptions are merely specific implementations of the present application, but are not intended to limit the claimed scope of the present application. Those skilled in the art will appreciate that any modification or substitution readily obtained by those skilled in the art within the technical scope disclosed in the present application shall fall within the claimed scope and the disclosure of the present application.

## Claims

1. A modified lithium iron(III) oxide material, comprising a nickel-doped lithium iron(III) oxide substrate, and an iron-nickel lithium oxide layer and a carbon coating layer sequentially stacked on the surface of the nickel-doped lithium iron(III) oxide substrate, wherein the iron-nickel lithium oxide layer is generated in situ on the surface of the nickel-doped lithium iron(III) oxide substrate, and in the modified lithium iron(III) oxide material, the molar ratio of lithium to iron is 5:(0.9 to 1.1), the molar ratio of nickel to lithium is (0.01 to 0.05):5, and the carbon coating content is 0.5 wt% to 5 wt%.

2. The modified lithium iron(III) oxide material according to claim 1, wherein the average thickness of the carbon coating layer is 10 to 500 nm.

3. The modified lithium iron(III) oxide material according to claim 1, wherein the carbon source forming the carbon coating layer is a gaseous carbon source, including any one or a combination of at least two of ethylene, ethyne, methane, ethane, propylene, propane, and butene.

4. The modified lithium iron(III) oxide material according to claim 1, wherein the residual base content of the modified lithium iron(III) oxide material is less than 5%.

5. A method for preparing a modified lithium iron(III) oxide material, comprising:

    (1) mixing a lithium source and an iron source, and sintering the mixture to give a lithium iron(III) oxide substrate;
    (2) grinding the lithium iron(III) oxide substrate and a nickel source to give a nickel-doped lithium iron(III) oxide substrate; and
    (3) subjecting the nickel-doped lithium iron(III) oxide substrate obtained in step (2) to gas-phase carbon coating with a carbon source to give the modified lithium iron(III) oxide material.

6. The method according to claim 5, wherein in step (1), the lithium source includes any one or a combination of at least two of lithium oxide, lithium hydroxide, lithium carbonate, lithium chloride, lithium nitrite, lithium nitrate, lithium oxalate, lithium acetate, and lithium phosphate;

    preferably, the iron source includes any one or a combination of at least two of ferric chloride, ferrosoferric oxide, ferric oxide, ferric hydroxide, ferric oxyhydroxide, ferric nitrate, ferric acetate, ferric citrate, ferric phosphate, ferrous oxalate, ferric formate, and iron(III) acetate;
    preferably, the molar ratio of lithium in the lithium source to iron in the iron source is 5:(0.9 to 1.1).

7. The method according to claim 5, wherein the sintering comprises a primary sintering and a secondary sintering; the temperature of the secondary sintering is higher than that of the primary sintering.

8. The method according to claim 5, wherein in step (2), the nickel source includes any one or a combination of at least two of nickel monoxide, nickel trioxide, nickel hydroxide, nickel oxide hydroxide, nickel nitrate, nickel nitrite, nickel carbonate, nickel oxalate, and nickel acetate;
    preferably, the molar ratio of nickel in the nickel source to lithium in the lithium source is (0.01 to 0.05):5.

9. The method according to claim 5, wherein in step (2), the lithium iron(III) oxide substrate is pulverized and sieved before the grinding;

    preferably, the grinding includes mechanochemical ball milling;
    preferably, the ball-to-material ratio of the mechanochemical ball milling is (10 to 45):1.

10. The method according to claim 5, wherein in step (3), the carbon source includes any one or a combination of at least two of ethylene, ethyne, methane, ethane, propylene, propane, and butene;
preferably, the gas-phase carbon coating is performed in an inert gas atmosphere.

11. A positive-electrode plate, comprising the modified lithium iron(III) oxide material according to any one of claims 1 to 4 or a modified lithium iron(III) oxide material prepared by the method according to any one of claims 5 to 10.

12. A lithium-ion battery, comprising the positive-electrode plate according to claim 11.

FIG. 1

FIG. 2

## INTERNATIONAL SEARCH REPORT

International application No.

**PCT/CN2024/115014**

**A. CLASSIFICATION OF SUBJECT MATTER**

H01M 4/36(2006.01)i; H01M 4/525(2010.01)i

According to International Patent Classification (IPC) or to both national classification and IPC

**B. FIELDS SEARCHED**

Minimum documentation searched (classification system followed by classification symbols)

IPC: H01M4/-

Documentation searched other than minimum documentation to the extent that such documents are included in the fields searched

Electronic data base consulted during the international search (name of data base and, where practicable, search terms used)

CJFD, CNTXT, DWPI, ENTXTC, CNKI, ISI_Web of Science: 研一新材料, 铁酸锂, 包, 覆, 核壳, 壳核, 镍, 掺杂, 机械化学, 机械力, 球磨, 研磨, 原位, 残碱, 气体, Li5FeO4, lithium ferrite, coat+, core shell, shell core, core-shell, shell-core, Ni, nickel, milling, in situ, gas, mechanochemistry, mechanical force, residual base

**C. DOCUMENTS CONSIDERED TO BE RELEVANT**

| Category* | Citation of document, with indication, where appropriate, of the relevant passages | Relevant to claim No. |
|---|---|---|
| Y | CN 110459748 A (HUBEI RT ADVANCED MATERIALS CO., LTD.) 15 November 2019 (2019-11-15)<br>description, paragraphs [0027]-[0030], [0032]-[0033], [0038], and [0042]-[0043] | 1-12 |
| Y | CN 115579474 A (WUXI LINGYI WEILAI NEW MATERIAL TECHNOLOGY RESEARCH INSTITUTE CO., LTD.) 06 January 2023 (2023-01-06)<br>description, paragraphs [0021]-[0024] | 1-12 |
| Y | CN 116505103 A (SHENZHEN DEFANG CHUANGYU NEW ENERGY TECHNOLOGY CO., LTD. et al.) 28 July 2023 (2023-07-28)<br>description, paragraphs [0036]-[0038], [0056]-[0058], [0060], [0063], and [0078], and figure 1 | 1-12 |
| A | CN 115986077 A (SVOLT ENERGY TECHNOLOGY CO., LTD.) 18 April 2023 (2023-04-18)<br>entire description | 1-12 |

☑ Further documents are listed in the continuation of Box C. ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **22 October 2024** | **29 October 2024** |

| Name and mailing address of the ISA/CN | Authorized officer |
|---|---|
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/115014** |

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | CN 116544533 A (SHENZHEN DEFANG CHUANGYU NEW ENERGY TECHNOLOGY CO., LTD. et al.) 04 August 2023 (2023-08-04)<br>entire description | 1-12 |
| A | WO 2023048550 A1 (LG CHEMICAL LTD.) 30 March 2023 (2023-03-30)<br>entire description | 1-12 |

Form PCT/ISA/210 (second sheet) (July 2022)

## INTERNATIONAL SEARCH REPORT
### Information on patent family members

| International application No. |
| --- |
| **PCT/CN2024/115014** |

| Patent document cited in search report | | | Publication date (day/month/year) | Patent family member(s) | | | Publication date (day/month/year) |
| --- | --- | --- | --- | --- | --- | --- | --- |
| CN | 110459748 | A | 15 November 2019 | None | | | |
| CN | 115579474 | A | 06 January 2023 | None | | | |
| CN | 116505103 | A | 28 July 2023 | None | | | |
| CN | 115986077 | A | 18 April 2023 | None | | | |
| CN | 116544533 | A | 04 August 2023 | WO | 2024078414 | A1 | 18 April 2024 |
| WO | 2023048550 | A1 | 30 March 2023 | US | 2024258527 | A1 | 01 August 2024 |
| | | | | JP | 2024519879 | A | 21 May 2024 |

Form PCT/ISA/210 (patent family annex) (July 2022)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 108878849 A

- CN 110459748 A